# EUROPEAN PATENT APPLICATION

(11) **EP 2 669 940 A1**
(43) Date of publication of application: **04.12.2013**
(21) Application number: 12739563.0
(22) Date of filing: 24.01.2012
(51) Int. Cl.: H01L 23/02, C03C 27/02, G01P 15/08, G01P 15/125, H01L 23/04, H01L 23/06, H01L 23/14, H01L 29/84

(54) **SUBSTRATE WITH THOUGH ELECTRODE AND METHOD FOR PRODUCING SAME**

(30) Priority: 27.01.2011 JP 2011015814
(71) Applicant: Panasonic Corporation, Osaka 571-8501 (JP)
(72) Inventor: HOZUMI, Junichi, Shiromi, Chuo-ku Osaka 540-6207 (JP); TAURA, Takumi, Shiromi, Chuo-ku Osaka 540-6207 (JP); OKUMURA, Shin, Shiromi, Chuo-ku Osaka 540-6207 (JP); NAKATANI, Tomohiro, Shiromi, Chuo-ku Osaka 540-6207 (JP); TOMOIDA, Ryo, Shiromi, Chuo-ku Osaka 540-6207 (JP)
(74) Representative: Appelt, Christian W.
(86) International application number: PCT/JP2012/051391
(87) International publication number: WO 2012/102252

(57) **Abstract**

A method for producing a substrate with through-electrode includes the steps of: forming recesses 21 or through-holes 21B in either one of a silicon substrate 51 and a glass substrate 54; forming protrusions 52 in the other substrate; laying the silicon substrate 51 and glass substrate 54 on each other so that the protrusions 52 are inserted in the respective recesses 21 or through-holes 21B; and bonding the silicon substrate 51 and the glass substrate 54 to each other.

## Description

### TECHNICAL FIELD

The present invention relates to a substrate with through-electrode and a method for producing the same.

### BACKGROUND ART

As a conventional method for producing a substrate with through-electrode, for example, a technique described in Patent Literature 1 is known.

Patent Literature 1 discloses a method for producing a flat substrate (substrate with through-electrode) made of a glass material. Actually, the flat substrate made of a glass material is produced as follows. First, recesses are formed in the surface of a flat silicon substrate, and a flat glass substrate is laid on the surface of the silicon substrate in which the recesses are formed. The glass substrate is then heated, whereby part of the glass substrate fills the recesses. Thereafter, the glass substrate is solidified again, and each side of the flat substrate is polished to remove silicon.

### CITATION LIST

### PATENT LITERATURE

Patent Literature 1: Japanese Patent Publication No. 4480939

### SUMMARY OF INVENTION

### PROBLEMS TO BE SOLVE BY INVENTION

However, the aforementioned conventional technique heats and melts the glass substrate for filling the recesses with part of the glass substrate. Accordingly, the thermal stress could act and influence the device characteristics.

Therefore, an object of the present invention is to provide a substrate with through-electrode with the influence on the device characteristics minimized and the method for producing the same.

### MEANS FOR SOLVING PROBLEM

The present invention is a method for producing a substrate with through-electrode including the steps of: forming a recess or a through-hole in either one of silicon and glass substrates; forming a protrusion in the other substrate; laying the silicon substrate and glass substrate on each other so that the protrusion is inserted in the recess or through-hole; and bonding the silicon substrate and the glass substrate to each other.

Moreover, the substrate with through-electrode may further includes the step of exposing the glass substrate and silicon substrate at least in one side of a bonded substrate having the silicon substrate and glass substrate bonded to each other.

Furthermore, the silicon substrate and glass substrate may be bonded to each other while the substrate with the protrusion formed covers an opening of the recess or an opening of the through-hole to prevent formation of a void.

Still furthermore, a gap may be formed between the protrusion and the recess or between the protrusion and the through-hole.

Also, the present invention is a substrate with through-electrode including a glass substrate that includes a through-electrode formed therein, in which a gap is formed between the through-electrode and the glass substrate.

### ADVANTAGEOUS EFFECT OF INVENTION

According to the present invention, it is possible to provide a substrate with through-electrode with the influence due to thermal stress minimized and the producing method thereof.

### BRIEF DESCRIPTION OF DRAWINGS

[Fig. 1] Figs. 1(a) and 1(b) are views illustrating a semiconductor device according to a first embodiment of the present invention, Fig. 1(a) being a perspective view illustrating the structure of a package lid, and Fig. 1 (b) being a perspective view illustrating the structure thereof other than the lid.
[Fig. 2] Fig. 2 is an exploded perspective view illustrating a schematic configuration of an acceleration sensor chip according to the first embodiment of the present invention.
[Fig. 3] Fig. 3 is a cross-sectional view illustrating a schematic structure of the acceleration sensor chip according to the first embodiment of the present invention.
[Fig. 4] Figs. 4(a) to 4(c) are cross-sectional views schematically illustrating a method for producing a glass substrate according to the first embodiment of the present invention.
[Fig. 5] Figs. 5(a) to 5(c) are cross-sectional views schematically illustrating a method for producing a silicon substrate according to the first embodiment of the present invention.
[Fig. 6] Figs. 6(a) to 6(e) are cross-sectional views schematically illustrating a method for producing a substrate with through-electrode according to the first embodiment of the present invention.
[Fig. 7] Figs. 7(a) to 7(c) are cross-sectional views schematically illustrating a method for producing a silicon substrate according to a modification of the first embodiment of the present invention.
[Fig. 8] Figs. 8(a) to 8(c) are cross-sectional views schematically illustrating a method for producing a glass substrate according to the modification of the first embodiment of the present invention.
[Fig. 9] Figs. 9(a) to 9(e) are cross-sectional views schematically illustrating a method for producing a substrate with through-electrode according to the modification of the first embodiment of the present invention.
[Fig. 10] Fig. 10 is a cross-sectional view illustrating a schematic structure of an acceleration sensor chip according to a second embodiment of the present invention.
[Fig. 11] Figs. 11(a) to 11 (c) are cross-sectional views schematically illustrating a method for producing a glass substrate according to the second embodiment of the present invention.
[Fig. 12] Figs. 12 (a) to 12 (c) are cross-sectional views schematically illustrating a method for producing a silicon substrate according to the second embodiment of the present invention.
[Fig. 13] Figs. 13(a) to 13(c) are cross-sectional views schematically illustrating a method for producing a substrate with through-electrode according to the second embodiment of the present invention.
[Fig. 14] Figs. 14 (a) to 14 (c) are cross-sectional views schematically illustrating a method for producing a glass substrate according to a modification of the second embodiment of the present invention.
[Fig. 15] Figs. 15(a) to 15(c) are cross-sectional views schematically illustrating a method for producing a silicon substrate according to the modification of the second embodiment of the present invention.
[Fig. 16] Figs. 16(a) to 16(d) are cross-sectional views schematically illustrating a method for producing a substrate with through-electrode according to the modification of the second embodiment of the present invention.
[Fig. 17] Fig. 17 is a cross-sectional view illustrating a schematic structure of an acceleration sensor chip according to a third embodiment of the present invention.
[Fig. 18] Figs. 18 (a) to 18 (c) are cross-sectional views schematically illustrating a method for producing a glass substrate according to the third embodiment of the present invention.
[Fig. 19] Figs. 19(a) to 19(c) are cross-sectional views schematically illustrating a method for producing a silicon substrate according to the third embodiment of the present invention.
[Fig. 20] Figs. 20(a) to 20(c) are cross-sectional views schematically illustrating a method for producing a substrate with through-electrode according to the third embodiment of the present invention.

### DESCRIPTION OF EMBODIMENTS

Hereinbelow, a description is given in detail of embodiments of the present invention with reference to the drawings. The following shows a substrate with through-electrode for use in an acceleration sensor, which is a capacitance sensor, as an example. The side, of the silicon substrate, where movable electrodes of weight portions are formed is defined as a front side of the silicon substrate. In the following description, the short-side direction of the silicon substrate is a direction X, the long-side direction thereof is a direction Y, and the thickness direction thereof is a direction Z.

Moreover, the plurality of embodiments below include the same constituent elements. Accordingly, in the following, the same constituent elements are given the same reference numerals, and redundant description is omitted.

### (First Embodiment)

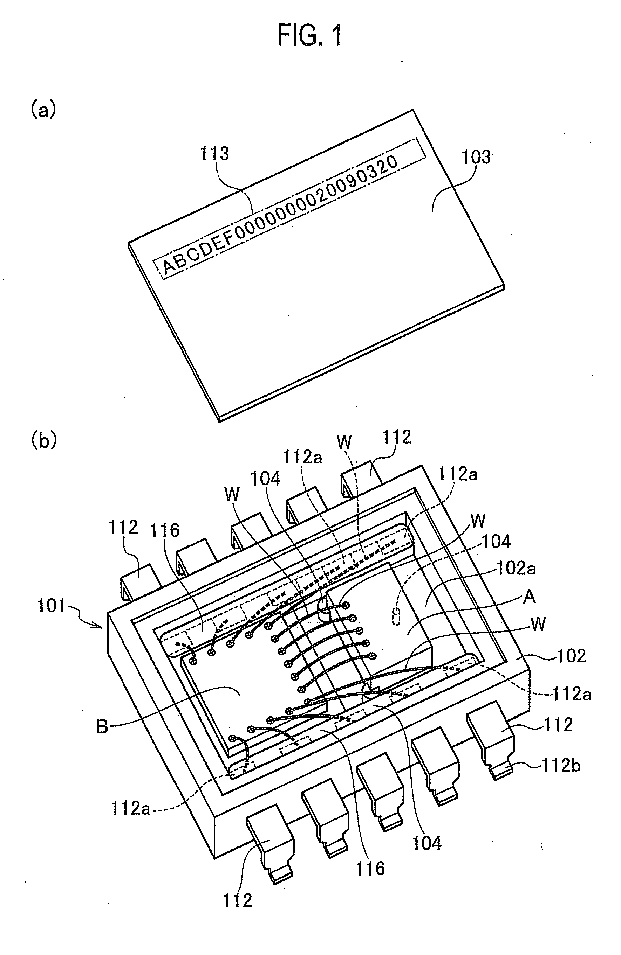

As shown in Figs. 1(a) and 1(b), a semiconductor device 1 according to a first embodiment includes: an acceleration sensor chip (an acceleration sensor: a semiconductor device) A as an example of a MEMS device; and a control IC chip B having a signal processing circuit that processes signals outputted from the acceleration sensor chip A. The semiconductor device 1 further includes a surface-mount package 101, which accommodates the acceleration sensor chip A and the control IC chip B.

The package 101 includes: a plastic package body 102 having a box shape in which one face located at the top in Fig. 1(b) is opened; and a package lid 103 that closes the open face of the package 101. The plastic package body 102 includes plural leads 112 electrically connected to the acceleration sensor chip A and control IC chip B.

Each lead 112 includes: an outer lead 112b drawn out from the outer side surface of the plastic package body 102; and an inner lead 112a drawn out from the inner side surface of the plastic package body 102.

The inner leads 112a are electrically connected to respective pads included in the control IC chip B through bonding wires W.

The acceleration sensor chip A is fixed to a mount surface 102a, which is located at the bottom of the plastic package body 102, through adhesive portions 104. The adhesive portions 104 are provided at three places corresponding to three vertices of a virtual triangle defined based on the outer shape of the acceleration sensor chip A. Each adhesive portion 104 includes a truncated-cone shaped protrusion integrally and continuously protruded from the plastic package body 102; and an adhesive coating the protrusion. The adhesive is, for example, silicon-type resin such as silicon resin having an elastic modulus of not more than 1 Mpa.

Herein, on a major surface of the acceleration sensor chip A opposite to the open face of the plastic package body 102, all the pads provided for the acceleration sensor chip A are arranged along a side of the major surface. The adhesive portions 104 are located at vertices of a virtual triangle whose vertices are located at three places including two places on both ends of the side of interest and one place (for example, the center) of a side parallel to the side of interest. The pads can be, therefore, stably bonded to the respective bonding wires W. As for the positions of the adhesive portions 104, the place on the side parallel to the side of interest is not limited to the center but also may be one of both the ends, for example. However, if the adhesive portion 14 is located at the center, the acceleration sensor chip A can be supported more stably, and the bonding wires W can be stably bonded to the respective pads.

The control IC chip B is a semiconductor chip including a plurality of semiconductor elements formed on a semiconductor substrate composed of single-crystal silicon or the like, wires connecting the same, and a passivation film protecting the semiconductor elements and wires from the external environment. The entire rear surface of the control IC chip B is fixed to the bottom surface of the plastic package body 102 by silicon-type resin. The signal processing circuit formed on the control IC chip B may be properly designed depending on the function of the acceleration sensor chip A and only needs to cooperate with the acceleration sensor chip A. For example, the control IC chip B can be formed as an ASIC(application specific IC).

To produce the semiconductor device of Fig. 1, first, a die-bonding process is performed to fix the acceleration sensor chip A and control IC chip B to the plastic package body 102. Then, a wire bonding process is performed to electrically connect the acceleration sensor chip A to the control IC chip B and connect the control IC chip B to the inner leads 112a through the bonding wires W. Thereafter, a resin coating formation process is performed to form resin coating portions 116, and a sealing process is performed to join the outer periphery of the package lid 103 to the plastic package body 102. The inside of the plastic package body 102 is thus sealed in an airtight state. In a proper portion of the package lid 103, an indication including the product name, producing date, and the like is formed by a laser marking technique.

In this embodiment, the control IC chip B is formed by use of one silicon substrate while the acceleration sensor chip A is formed by use of plural stacked substrates. The acceleration sensor chip A is thicker than the control IC chip B. Accordingly, in the bottom of the plastic package body 102, the mount surface 102a on which the acceleration sensor chip A is mounted, is recessed lower than the portion where the control IC chip B is mounted. The bottom of the plastic package body 102 is thinner in the portion of the acceleration sensor chip A than the other portion.

Furthermore, in the first embodiment, the plastic package body 102 has a cuboid profile of 10 mm×7 mm×3 mm. However, the profile and the numerals are just illustrative, and the profile of the plastic package body 102 can be properly set depending on the profiles of the acceleration sensor chip A and control IC chip B, the number of leads 112, the pitch thereof, and the like.

The material of the plastic package body 102 is liquid-crystal polyester (LCP) which is a kind of thermoplastic resin and has extremely low permeabilities of oxygen and vapor. However, the material of the plastic package body 102 is not limited to LCP and may be polyphenylene sulfite (PPS), polybisamide triazole (PBT), or the like, for example.

The material of each lead 112, that is, the material of a lead frame as a base of each lead 112 is phosphor bronze, which has a high spring characteristic among copper alloys. Herein, the lead frame includes a lead frame which is made of phosphor bronze and has a thickness of 0.2 mm and a plating film formed thereon by electrolytic plating. The plating film is composed of a film stack of Ni film having a thickness of 2 to 4 µm and Au film having a thickness of 0.2 to 0.3 µm. This can provide both the bonding reliability at wire bonding and the soldering reliability. The plastic package body 102, as a thermoplastic resin molding, is provided with the leads 112 simultaneously and integrally formed. However, the plastic package body 102 made of LCP as thermoplastic resin has low adhesion to the Au film of the leads 112. Accordingly, in this embodiment, a punched hole is provided in part of the aforementioned lead frame which is embedded in the package body 102, thus preventing the individual leads 112 from falling off.

The semiconductor device of Fig. 1 includes the resin coating portions 116 covering the exposed portions of the inner leads 112a and the vicinity thereof. The resin coating portions 116 are made of non-permeable resin such as epoxy resin including amine epoxy resin, for example. In this embodiment, after the wire bonding process, this non-permeable resin is applied using a dispenser and is cured to form the resin coating portions 116, thus increasing the airtightness. The rein coating portions 116 may be made of ceramics instead of the non-permeable resin. In the case of using ceramics, ceramics may be locally sprayed using a technique such as plasma thermal spray.

Moreover, each bonding wire is Au wire having a higher corrosion resistance than Al wire. In this embodiment, each bonding wire is Au wire having a diameter of 25 µm. The bonding wire is not limited to this and can be properly selected from Au wires having diameters of 20 to 50 µm.

Next, a description is given of the schematic structure of the acceleration sensor chip A.

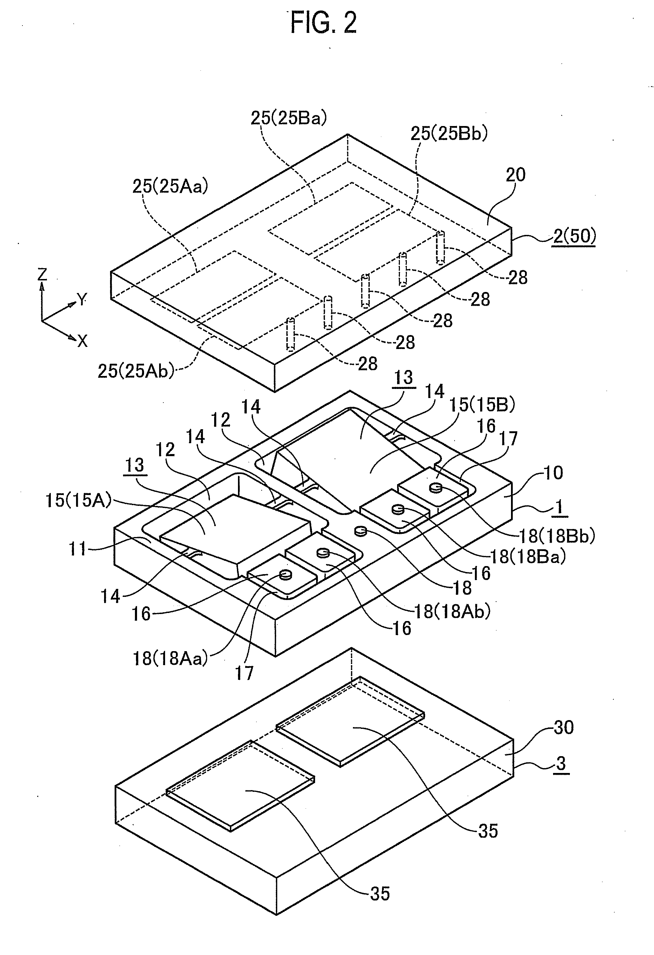

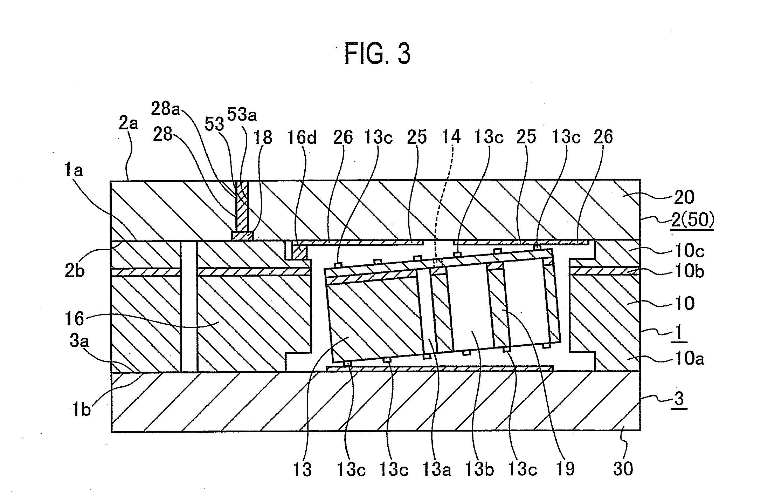

The acceleration sensor chip A is a capacitance acceleration sensor chip. The acceleration sensor chip A includes: a sensor body 1 formed by use of an SOI (silicon on insulator) substrate 10; a first fixed substrate 2 formed by use of a glass substrate 20; and a second fixed substrate 3 formed by use of a glass substrate 30. The first fixed substrate 2 is fixed to the one surface 1a side of the sensor body 1 (the top side in Figs. 2 and 3), and the second fixed substrate 3 is fixed to the other surface 1b side of the sensor body 1 (the bottom side in Figs. 2 and 3). The first and second fixed substrates 2 and 3 have the same external dimensions as those of the sensor body 1.

To show the individual structures of the sensor body 1 and the first and second fixed substrates 2 and 3, Fig. 2 illustrates the state where the sensor body 1, the first fixed substrate 2, and the second fixed substrate 3 are separated from one another. Instead of the SOI substrate 10, the sensor body 1 may be composed of a normal silicon substrate not including an insulating layer, for example. Moreover, the first and second fixed substrates 2 and 3 may be composed of either a silicon substrate or a glass substrate.

The sensor body 1 includes : a frame portion 11 including two open windows 12 each being rectangular in planar view; two weight portions 13 each being rectangular in planar view; and pairs of support spring portions 14. The open windows 12 are arranged along the one surface 1a side by side. The weight portions 13 are provided within the respective windows 12 of the frame portion 11. The pairs of support spring portions 14 connect the frame portion 11 and the respective weight portions 13.

The two weight portions 13 each having a rectangular planar view are spaced away from the first and second fixed substrates 2 and 3. On the maj or surfaces of the weight portions 13, which face the first fixed substrate 2 (the top faces in Figs. 2 and 3), movable electrodes 15A and 15B are provided. The entire periphery of the frame portion 11 surrounding the weight portions 13 is bonded to the first and second fixed substrates 2 and 3. The frame portion 11 and the first and second fixed substrates 2 and 3 thus constitute the chip-size package accommodating the weight portions 13 and later-described fixed elements 16.

Each pair of support spring portions 14 is arranged so as to sandwich the corresponding weight portion 13 within one of the open windows 12 of the frame portion 11 along a straight line passing through the center of gravity of the weight portion 13. Each support spring portion 14 is a torsion spring (a torsion bar) capable of twisting and is thinner than the frame portion 11 and weight portions 13. The weight portions 13 are capable of being displaced around the respective pairs of the support spring portions 14 relative to the frame portion 11.

In the frame portion 11 of the sensor body 1, window holes 17 each having a rectangular plan view communicate with the respective open windows 12 and are arranged side by side in the same direction as the two open windows 12 are arranged. Within each of the window holes 17, two fixed elements 16 are arranged along the direction that the pair of support spring portions 14 are arranged side by side.

There are spaces between the fixed elements 16 and the inner side surface of each window hole 17, between the fixed elements 16 and the outer side surface of each weight portion 13, and between the adjacent fixed elements 16. The fixed elements 16 and the window holes 17, the fixed elements 16 and the weight portions 13, and the adjacent fixed elements 16 are separated and independent of each other for electrical insulation. The fixed elements 16 are bonded to the first and second fixed substrates 2 and 3. On the one surface 1a side of the sensor body 1, circular electrode pads 18 are formed on the respective fixed elements 16. Each circular electrode pad 18 is made of metallic thin film such as Al-Si film, for example. In a similar manner, on a portion of the frame 11 between the adjacent window holes 17, for example, a circular electrode pad 18 composed of metallic thin film such as Al-Si film, for example is formed.

The electrode pads 18 formed on the fixed elements 16 are electrically connected to later-described fixed electrodes 25, and the electrode pad 18 formed on the frame portion 11 is electrically connected to the movable electrodes 15A and 15B. The plural electrode pads 18 described above are arranged along one side of the rectangular outer circumference of the acceleration sensor chip A.

The first fixed substrate 2 includes: plural interconnections (through-electrodes) 28 penetrating between a first major surface 2a of the first fixed substrate 2 and a second major surface 2b opposed to the same (the surface laid on the sensor body 1); and plural fixed electrodes 25 formed on the second major surface 2b.

The pair of fixed electrodes 25Aa and 25Ab is arranged so as to face the movable electrode 15A. In a similar manner, the pair of fixed electrodes 25Ba and 25Bb is arranged so as to face the movable electrode 15B. Each fixed electrode 25 is composed of metallic thin film such as Al-Si film, for example.

The interconnections 28 are electrically connected to the respective electrode pads 18 of the sensor body 1 at the second major surface of the first fixed substrate 2. Therefore, the potentials of the fixed electrodes 25 and movable electrodes 15 can be individually extracted through the electrode pads 18 to the outside of the acceleration sensor chip A.

In this embodiment, the first fixed substrate 2 corresponds to the substrate with through-electrode 50 with interconnections (through-electrodes) 28 formed within the glass substrate 20.

Accordingly, the substrate with through-electrode 50 used as the first fixed substrate 2 of the first embodiment includes: through-holes 53 formed in the glass substrate 20; and the interconnections (through-electrodes) 28 which are embedded in the respective through-holes 53 so as to be exposed in the first and second major surfaces 2a and 2b. The interconnections (through-electrodes) 28 are embedded (filled) in the respective through-holes 53 so that there is no void between a side surface 28a of each interconnection (through-electrodes) 28 and an inner surface 53a which is formed in a portion corresponding to the corresponding through-hole 53 in the glass substrate 20. In other words, the through-holes 53 formed in the glass substrate 20 are sealed by the respective interconnections (through-electrodes) 28.

On the other hand, at the positions corresponding to the weight portions 13 in the one surface 3a of the second fixed substrate 3(the surface laid on the sensor body 1), adherence preventing films 35, which are composed of metallic thin film such as Al-Si film, for example, are provided. The adherence preventing films 35 prevent the displaced weight portions 13 from adhering to the second fixed substrate 3.

Next, a description is given of the structure of the acceleration sensor chip A.

The sensor body 1 is composed of the SOI substrate 10. The SOI substrate 10 includes: a support substrate 10a made of single-crystal silicon; an insulating layer 10b which is provided on the support substrate 10a and is made of silicon oxide film; and an n-type silicon layer (active layer) 10c provided on the insulating layer 10b.

The frame portion 11 and fixed elements 16 in the sensor body 1 are bonded to the first and second fixed substrates 2 and 3. On the other hand, the weight portions 13 are spaced from the first and second fixed substrates 2 and 3 and are supported on the frame portion 11 by the pairs of support spring portions 14.

Moreover, minute protrusions 13c are protruded from the surfaces of each weight portion 13 facing the first and second fixed substrates 2 and 3. The minute protrusions 13c are configured to limit excessive displacement of the weight protrusions 13. In each weight portion 13, recesses 13a and 13b each having a rectangular opening are formed. The recesses 13a and 13b are different in size, and a half of the weight portion 13 to the right of the straight line passing through the pair of support spring portions 14 is different in weight from the left half thereof.

Each interconnection 28 of the first fixed substrate 2 is electrically connected to the corresponding electrode pad 18. The electrode pad 18 is connected to the corresponding fixed electrode 25 through the fixed element 16, an access conductor 16d, and a metallic interconnection 26.

The aforementioned acceleration sensor chip A includes four pairs of the movable electrodes 15 provided for the sensor body 1 and the fixed electrodes 25 provided for the first fixed substrate 2. Each of pairs of the movable electrodes 15 and fixed electrodes 25 constitutes a variable capacitor. When acceleration is applied to the acceleration sensor chip A, that is, the weight portions 13, the support spring portions 14 twist to displace the weight portions 13. This changes the facing effective area of the paired fixed electrode 25 and movable electrode 15 and the distance between the same, thus changing the capacitance of the variable capacitor. The acceleration sensor chip A can detect acceleration based on the change in capacitance.

Next, a description is given of a method for producing a glass-embedded silicon substrate as an example of the though-electrode substrate 50 used as the first fixed substrate 2.

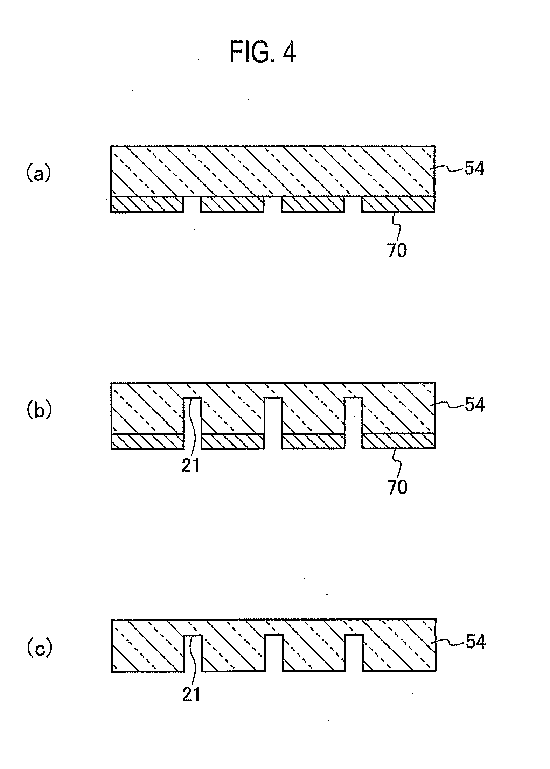

First, a description is given of a method of forming recesses 21 in the glass substrate 54. As shown in Fig. 4(a), the glass substrate 54 is prepared, and resist 70 is formed on the glass substrate 54. Thereafter, as shown in Fig. 4(b), predetermined areas in the surface of the glass substrate 54 are selectively removed by an RIE process or the like to form the recesses 21. After the recesses 21 are formed, as shown in Fig. 4(c) , the resist 70 is removed. In such a manner, the glass substrate 54 with the recesses 21 formed therein is formed (see Fig. 4(c)) .

Next, a description is given of a method of forming protrusions 52 in a silicon substrate 51.

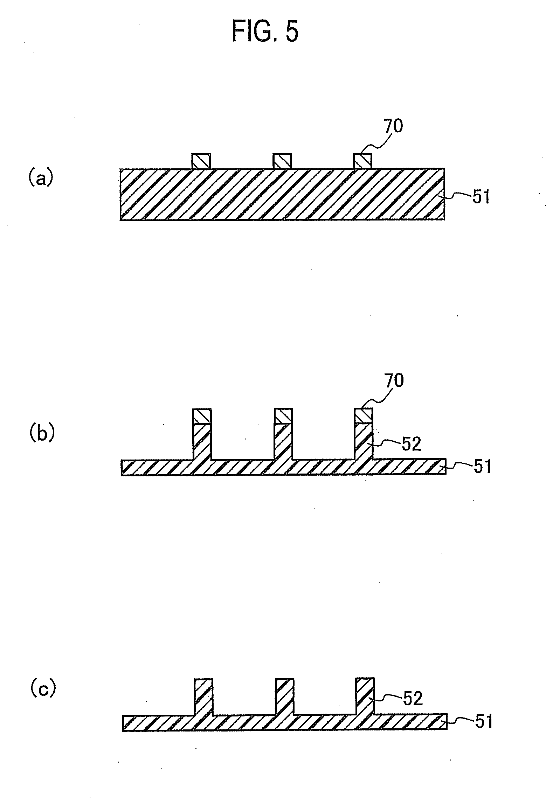

In this embodiment, first, as shown in Fig. 5(a), the silicon substrate 51 having an electric resistance small enough is prepared. In the entire silicon substrate 51, p-type or n-type impurities are added. Resist 70 is formed on the surface of the silicon substrate 51. Thereafter, as shown in Fig. 5(b) , predetermined areas in the surface of the silicon substrate 51 are selectively removed by an RIE process or the like to form the plural protrusions 52. After the protrusions 52 are formed, the resist 70 is removed as shown in Fig 5 (c). In such a manner, the silicon substrate 51 with the protrusions 52 formed therein is formed (see Fig. 5(c)). In this example, impurities are added in the entire silicon substrate 51, but the present invention is not limited to this. It suffices for the impurities to be added at least to the depth of part left as the interconnections (through-electrodes) 28.

In this embodiment, the glass substrate 54 corresponds to one of the silicon substrate and glass substrate, and the silicon substrate 51 corresponds to the other one thereof.

The formation of the protrusions 52 on the silicon substrate 51 can be performed either before or after the formation of the recesses 21 in the glass substrate 54 or can be performed in parallel with the formation of the recesses 21 in the glass substrate 54.

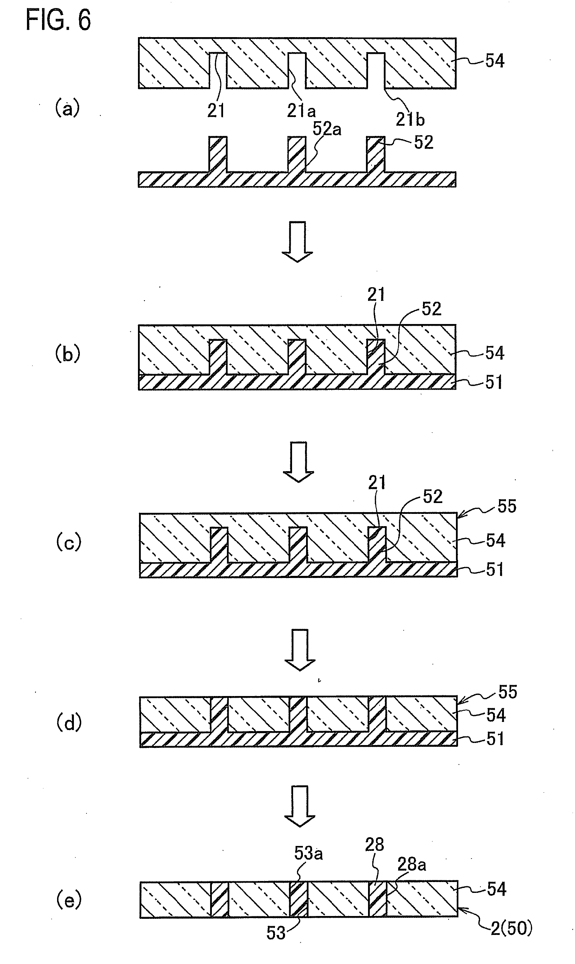

Next, the silicon substrate 51 and the glass substrate 54 are laid on each other so that the protrusions 52 are inserted in the respective recesses 21. Specifically, first, as shown in Fig. 6 (a), the glass substrate 54 with the recesses 21 formed therein and the silicon substrate 51 with the protrusions 42 formed therein are prepared. As shown in Fig. 6(b), as the protrusions 52 of the silicon substrate 51 are inserted into the protrusions 21 of the glass substrate 54, the silicon substrate 51 is laid on the glass substrate 54 so that the recesses 52 are inserted in the recesses 21. In this embodiment, each protrusion 52 is configured to have substantially the same shape as that of the recess 21 into which the protrusion 52 is inserted. The recesses 21 of the glass substrate 54 are engaged with the respective protrusions 52 of the silicon substrate 51 in a state that the silicon substrate 51 is laid on the glass substrate 54.

Next, as shown in Fig. 6(c), the silicon substrate 51 and glass substrate 54, which are laid on each other with the protrusions 52 inserted in the respective recesses 21, are bonded to each other by a method such as anodic bonding. This step may be performed either under ambient-pressure atmosphere or reduced-pressure atmosphere. Moreover, the bonding method is not limited to the anodic bonding and can be selected from various methods.

The silicon substrate 51 and glass substrate 54 are bonded to each other in such a manner to form a bonded substrate 55 is formed (see Fig. 6(c)).

The silicon substrate 51 and glass substrate 54 are bonded while the silicon substrate 51 with the protrusions 52 formed thereon covers openings 21b of the recesses 21 so as to prevent formation of void. In this embodiment, the shape of each protrusion 52 is substantially the same as that of the recess 21 into which the protrusion 52 is inserted, so that there is no void formed between side surfaces 52a of the protrusions 52 and inner surfaces 21a formed at the portions of the glass substrate 54 corresponding to the recesses 21 in a state where the protrusions 52 are inserted in the respective recesses 21. In other words, by filling the respective recesses 21 with the protrusions 52, the silicon substrate 51 covers the openings 21b of the recesses 21 so as to prevent formation of void, and in such a state, the silicon substrate 51 and glass substrate 54 are bonded to each other.

Thereafter, the glass substrate 54 and the silicon substrate 51 are exposed in at least one side of the bonded substrate 55, which has the silicon substrate 51 and glass substrate 54 bonded to each other.

In this embodiment, the glass substrate 54 and the silicon substrate 51 are exposed in both sides of the bonded substrate 55, which has the silicon substrate 51 and glass substrate 54 bonded to each other.

Specifically, as shown in Fig. 6(d), the part of the glass substrate 54 which is embedded in the silicon substrate 51 is left while the other part thereof is removed. As shown in Fig. 6(e), the part of the silicon substrate 51 which is embedded in the glass substrate 54 is left while the other part thereof is removed.

In this removal step, the upper surface of the glass substrate 54 and the rear surface of the silicon substrate 51 are scraped off for removal of unnecessary glass and silicon using a method including diamond wheel grinding, polishing such as chemical mechanical polishing (CMP), dry etching such as RIE, or wet etching by HF. The removal of glass may be either performed before or after the removal of silicon or may be performed in parallel.

In such a manner, the glass-embedded silicon substrate (substrate with through-electrode) 50 with the interconnections (through-electrodes) 28 formed within the glass substrate 20 is formed.

The glass-embedded silicon substrate (substrate with through-electrode) 50 produced through the above-described steps is used as the first fixed substrate 2 shown in Figs. 2 and 3.

As described above, the glass-embedded silicon substrate (substrate with through-electrode) 50 according to the first embodiment is produced by the steps 1 to 5 below.

1. Step of forming the recesses (recesses or through-holes) 21 in the glass substrate 54 which is one of the silicon substrate 51 and glass substrate 54

2. Step of forming the protrusions 52 on the silicon substrate 51 which is the other substrate of the silicon substrate 51 and glass substrate 54

3. Step of laying the silicon substrate 51 on the glass substrate 54 so that the protrusions 52 are inserted in the respective recesses 21

4. Step of bonding the silicon substrate 51 to the glass substrate 54

5. Step of exposing the glass substrate 54 and silicon substrate 51 in both sides (at least one side) of the bonded substrate 55 composed of the silicon substrate 51 and glass substrate 54 bonded to each other

When the glass-embedded silicon substrate (substrate with through-electrode) 50 is formed by the aforementioned steps, heat treatment for melting the glass substrate is unnecessary, thus minimizing the influence on the device characteristics.

In this embodiment, the bonding of the silicon substrate 51 and glass substrate 54 is performed in a state where the silicon substrate 51 with the protrusions 52 formed thereon covers the openings 21b of the recesses 21 so as to prevent formation of void. Accordingly, it is possible to prevent formation of void between the silicon substrate 10 and glass substrate 20, thus producing a device whose inside is highly airtight.

In the above example of the first embodiment, the recesses 21 are formed in the glass substrate 54, and the protrusions 51 are formed on the silicon substrate 51. However, the protrusion-recess relationship between the glass substrate and silicon substrate may be reversed.

Specifically, a glass-embedded silicon substrate (substrate with through-electrode) 50A with the interconnections (through-electrodes) 28 formed within the glass substrate 20 may be formed in the following manner.

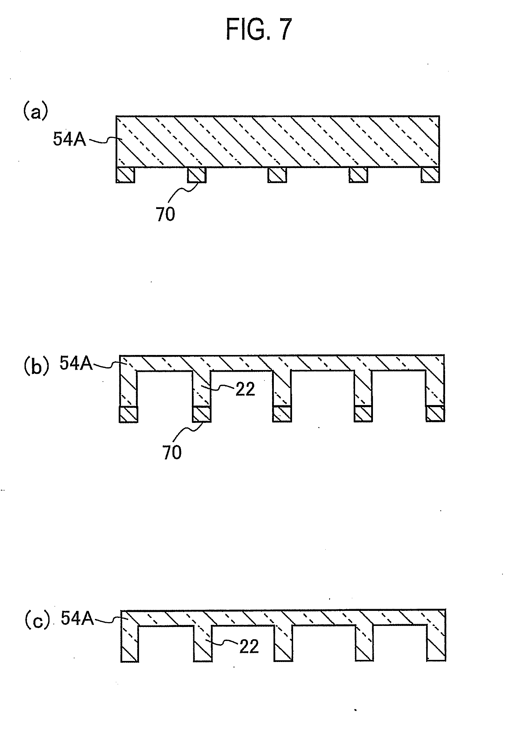

As shown in Fig. 7(a), a glass substrate 54A is prepared, and resist 70 is formed on the glass substrate 54A. Thereafter, as shown in Fig. 7(b), predetermined areas in the surface of the glass substrate 54A are selectively removed by an RIE process or the like to form protrusions 22. After the protrusions 22 are formed, as shown in Fig 7(c), the resist 70 is removed. In such a manner, the glass substrate 54A with the protrusions 22 formed therein is formed (see Fig. 7(c)).

Next, a description is given of a method of forming recesses 56 in a silicon substrate 51A.

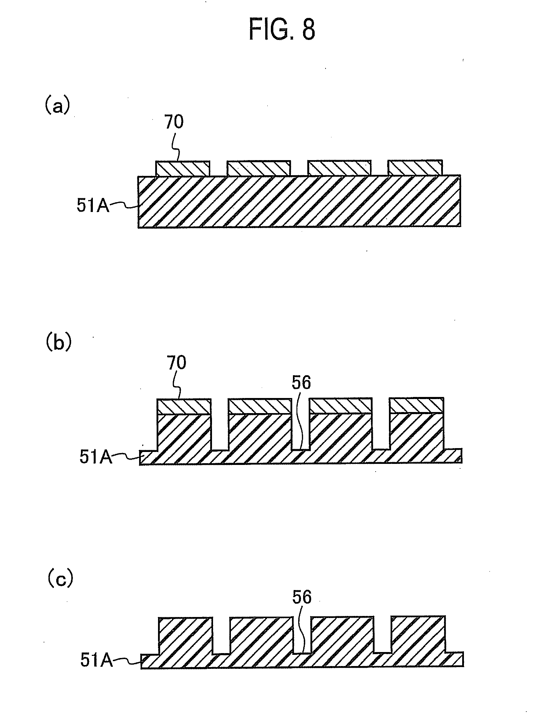

In this embodiment, first, as shown in Fig. 8(a), the silicon substrate 51A having an electric resistance small enough is prepared. In the entire silicon substrate 51A, p-type or n-type impurities are added. Resist 70 is then formed on the surface of the silicon substrate 51A. Thereafter, as shown in Fig. 8(b), predetermined areas in the surface of the silicon substrate 51A are selectively removed by an RIE process or the like to form recesses 56. After the recesses 56 are formed, the resist 70 is removed as shown in Fig. 8(c). In such a manner, the silicon substrate 51A with the recesses 56 formed therein is formed (see Fig. 8(c)). In this example, impurities are added to the entire silicon substrate 51A, but the present invention is not limited to this. The impurities only need to be added at least to the depth of part left as the interconnections (through-electrodes) 28.

In this embodiment, the silicon substrate 51A corresponds to one of the silicon substrate and glass substrate, and the glass substrate 54A corresponds to the other one thereof.

The formation of the recesses 56 in the silicon substrate 51A can be performed either before or after the formation of the protrusions 22 in the glass substrate 54A or can be performed in parallel with the formation of the protrusions 22 in the glass substrate 54A.

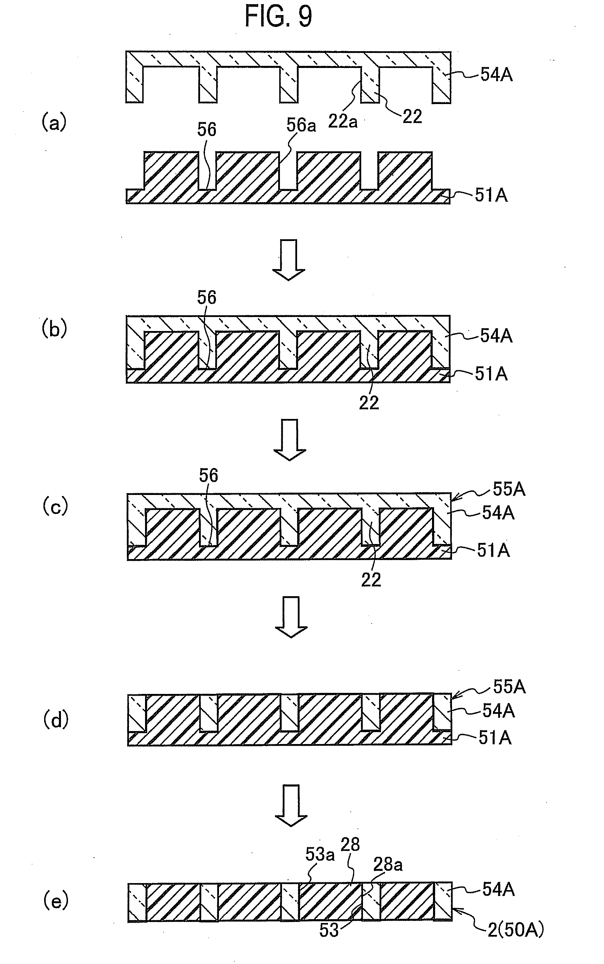

Next, the silicon substrate 51A and the glass substrate 54A are laid on each other so that the protrusions 22 are inserted in the respective recesses 56. Specifically, first, as shown in Fig. 9(a), the glass substrate 54A with the protrusions 22 formed thereon and the silicon substrate 51A with the recesses 56 formed therein are prepared. As shown in Fig. 9(b), as the protrusions 22 of the glass substrate 54A are inserted into the recesses 56 of the silicon substrate 51A, the silicon substrate 51A is laid on the glass substrate 54A so that the protrusions 22 are inserted in the recesses 56. In this embodiment, each protrusion 22 is configured to have shape substantially the same as that of the recess 56 into which the protrusion 22 is inserted. The protrusions 22 of the glass substrate 54A are engaged with the respective recesses 56 of the silicon substrate 51A in a state that the silicon substrate 51A and glass substrate 54A are laid on each other.

Next, as shown in Fig. 9(c), the silicon substrate 51A and glass substrate 54A, which are laid on each other with the protrusions 22 inserted in the respective recesses 56, are bonded by a method such as anodic bonding. This step may be performed either under ambient-pressure atmosphere or reduced-pressure atmosphere. Moreover, the bonding method is not limited to the anodic bonding and can be selected from various methods.

The silicon substrate 51A and glass substrate 54A are bonded in such a manner to form a bonded substrate 55 (see Fig. 9(c)).

The silicon substrate 51A and glass substrate 54A are bonded while the glass substrate 54A with the protrusions 22 formed therein covers openings 56b of the recesses 56 so as to prevent formation of void. In this embodiment, the shape of each protrusion 22 is substantially the same as those of the recess 56 into which the protrusion 22 is inserted, so that there is no void formed between side surfaces 22a of the protrusions 22 and inner surfaces 56a formed at the portions of the silicon substrate 51A corresponding to the recesses 56 in a state where the protrusions 22 are inserted in the respective recesses 56. In other words, by filling the recesses 56 with the protrusions 22, the glass substrate 54A covers the openings 56b of the recesses 56 so as to prevent formation of void, and in such a state, the silicon substrate 51A and glass substrate 54A are bonded to each other.

Thereafter, the glass substrate 54A and the silicon substrate 51A are exposed in at least one side of the bonded substrate 55A, which has the silicon substrate 51 and glass substrate 54A bonded to each other.

In this embodiment, the glass substrate 54A and the silicon substrate 51A are exposed in both sides of the bonded substrate 55A, which has the silicon substrate 51A and glass substrate 54A bonded to each other.

Specifically, as shown in Fig. 9(d), the part of the glass substrate 54A which is inserted in the silicon substrate 51A is left, while the other part thereof is removed. As shown in Fig. 9(e), the part of the silicon substrate 51A in which the glass substrate 54 is embedded is left, while the other part thereof is removed.

In this removal step, the upper surface of the glass substrate 54A and the rear surface of the silicon substrate 51A are scraped off for removal of unnecessary glass and silicon by using a method including diamond wheel grinding, polishing such as chemical mechanical polishing (CMP), dry etching such as RIE, or wet etching by HF. The removal of glass may be performed either before or after the removal of silicon or may be performed in parallel.

In such a manner, the glass-embedded silicon substrate (substrate with through-electrode) 50A with the interconnections (through-electrodes) 28 formed within the glass substrate 20 is formed.

The glass-embedded silicon substrate (substrate with through-electrode) 50A formed in such a manner can provide the same operations and effects as those of the aforementioned first embodiment.

### (Second Embodiment)

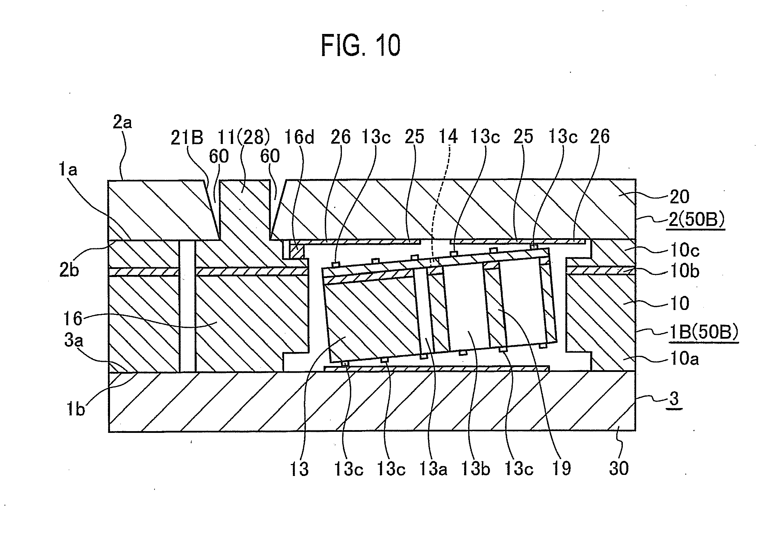

Fig. 10 is a cross-sectional view showing a schematic structure of an acceleration sensor chip A according to a second embodiment of the present invention. The acceleration sensor chip A according to the second embodiment basically has substantially the same structure as that of the acceleration sensor chip A shown in the above first embodiment.

Specifically, the acceleration sensor chip A according to the second embodiment is a capacitance acceleration sensor chip. The acceleration sensor chip A includes: a sensor body 1B formed by use of a silicon substrate (SOI substrate) 10; a first fixed substrate 2 formed by use of a glass substrate 20; and a second fixed substrate 3 formed by use of a glass substrate 30.

The second embodiment is the same as the first embodiment in that the acceleration sensor chip A employs a substrate with through-electrode. However, the acceleration sensor chip A of the second embodiment has a structure in which protrusions 11 of the silicon substrate 10 are inserted in respective through-holes 21B formed in the glass substrate 20. Hereinafter, a description is given of a method for producing a substrate with through-electrode 50B according to the second embodiment.

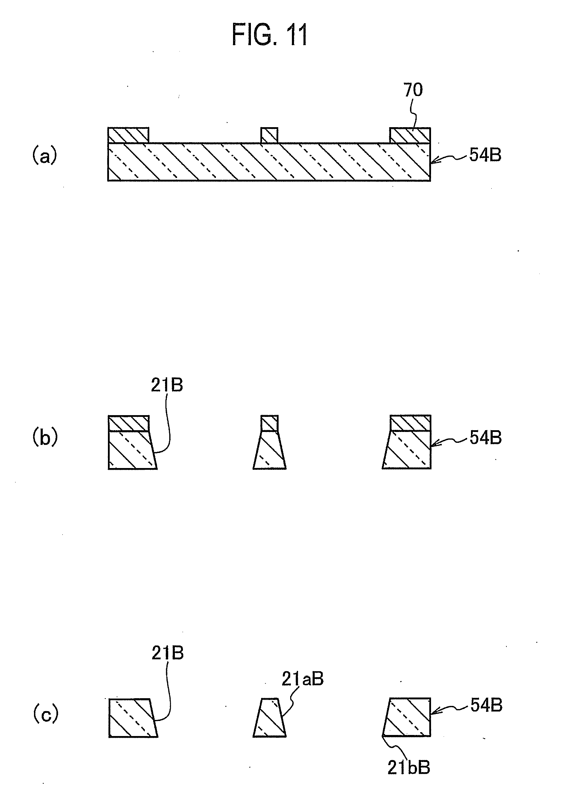

First, the through-holes 21B are formed in a glass substrate 54B. Specifically, as shown in Fig. 11(a), first, the glass substrate 54B is prepared, and resist 70 is provided on the glass substrate 54B. Thereafter, as shown in Fig. 11(b), predetermined areas in the surface of the glass substrate 54B are selectively removed by an RIE process or the like to form the through-holes 21B. After the through-holes 21 are formed, the resist 70 is removed as shown in Fig 11 (c). In such a manner, the glass substrate 54B with the through-holes 21B formed therein is formed (see Fig. 11(c)).

Next, a description is given of a method of forming the protrusions 11 in a silicon substrate 51B.

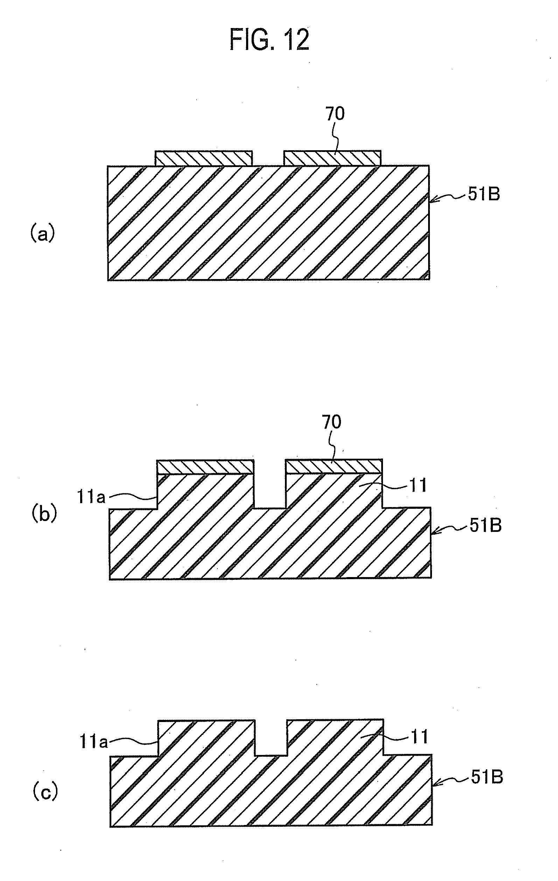

In the second embodiment, first, as shown in Fig. 12(a), the silicon substrate 51B having an electric resistance small enough is prepared. In the entire silicon substrate 51B, p-type or n-type impurities are added. Resist 70 is formed on the surface of the silicon substrate 51B. Thereafter, as shown in Fig. 12(b), predetermined areas in the surface of the silicon substrate 51B are selectively removed by an RIE process or the like to form the plural protrusions 11. After the protrusions 11 are formed, the resist 70 is removed as shown in Fig. 12 (c). In such a manner, the silicon substrate 51B with the protrusions 11 formed thereon is formed (see Fig. 12(c)). In this example, impurities are added to the entire silicon substrate 51, but the present invention is not limited to this. The impurities only need to be added to at least the depth of part left as the interconnections (through-electrodes) 28.

In this embodiment, the glass substrate 54B corresponds to one of the silicon substrate and glass substrate, and the silicon substrate 51B corresponds to the other one thereof.

The formation of the protrusions 11 in the silicon substrate 51B can be performed either before or after the formation of the through-holes 21B in the glass substrate 54B or can be performed in parallel with the formation of the through-holes 21B in the glass substrate 54B.

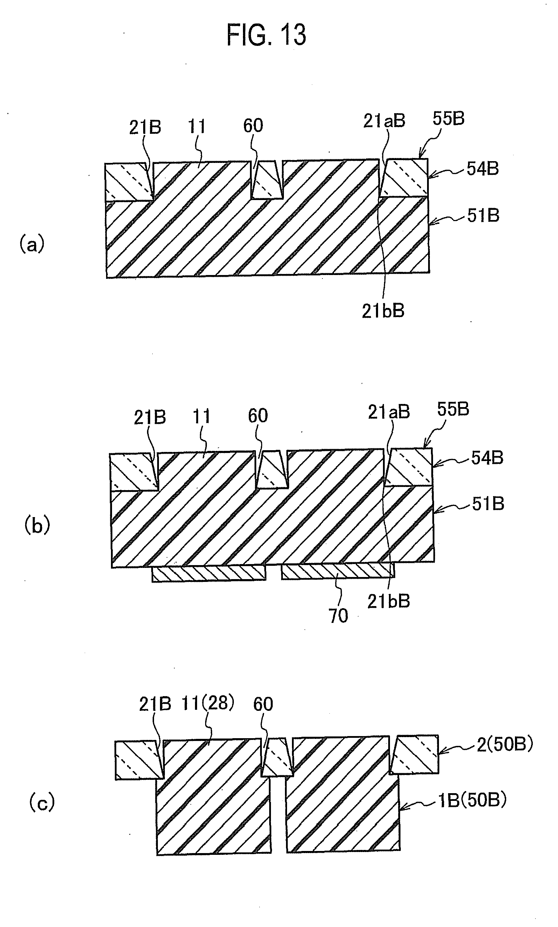

Next, the silicon substrate 51B and the glass substrate 54B are laid on each other so that the protrusions 11 are inserted in the respective through-holes 21B. Specifically, first, the glass substrate 54B with the through-holes 21B formed therein and the silicon substrate 51B with the protrusions 11 formed therein are prepared. As shown in Fig. 13(a), the protrusions 11 of the silicon substrate 51B are inserted into the through-holes 21B of the glass substrate 54, and the silicon substrate 51B is laid on the glass substrate 54B so that the protrusions 11 are in the respective through-holes 21B. In the second embodiment, each through-hole 21B has a tapered shape with the diameter increasing toward the top. The upper part of each through-hole 21B has a little larger diameter than that of the corresponding protrusion 11 of the silicon substrate 51B. Accordingly, there are small gaps 60 formed between glass and silicon (between side surfaces 11a of the protrusions 11 and inner surfaces 21aB formed at the portions of the glass substrate 54B corresponding to the respective through-holes 21B). Accordingly, the lower part of each through-hole 21B has such dimensions as the lower part can be properly engaged with the corresponding protrusion 11 of the silicon substrate 51B in a state where the silicon substrate 51B and the glass substrate 54B are laid on each other (see Fig. 13(a)).

Next, the silicon substrate 51B and glass substrate 54B, which are laid on each other with the protrusions 11 inserted in the respective through-holes 21B, are bonded by a method such as anodic bonding. This step may be performed either under ambient-pressure atmosphere or reduced-pressure atmosphere. Moreover, the bonding method is not limited to the anodic bonding and can be selected from various methods.

The silicon substrate 51B and glass substrate 54B are bonded in such a manner as to form a bonded substrate 55B (see Fig. 13(a)).

The bonding of the silicon substrate 51B and the glass substrate 54B is performed while the silicon substrate 51B with the protrusions 11 formed therein covers openings 21bB each on an end (the lower side) of the corresponding through-hole 21B so as to prevent formation of void. In the second embodiment, the through-holes 21B are formed so that the lower part of each through-hole 21B has such dimensions as the lower part thereof is properly engaged with the corresponding protrusion 11 of the silicon substrate 51B. In the state where the silicon substrate 51B and the glass substrate 54B are laid on each other with the protrusions 11 inserted in the through-holes 21B, the lower ends of the side surfaces 11a of the protrusions 11 abut on the respective lower ends of the inner surfaces 21aB formed at the portions of the glass substrate 54B corresponding to the through-holes 21B. In such a manner, the silicon substrate 51B with the protrusions 11 formed therein covers each opening 21bB located on an end (lower part) of the corresponding through-hole 21B so as to prevent formation of a void, and in such a state, the silicon substrate 51B and the glass substrate 54B are bonded.

Furthermore, resist 70 is formed on the rear surface of the silicon substrate 51B as shown in Fig. 13(b), and then predetermined areas of the silicon substrate 51B are selectively removed by an RIE process or the like as shown in Fig. 13(c).

In such a manner, the substrate with through-electrode 50B with the interconnections (through-electrodes) 28 formed within the glass substrate 20 is formed. In the second embodiment, the substrate with through-electrode 50B includes: the sensor body 1B with the interconnections (through electrodes) 28 formed; and the first fixed substrate 2 including the through-holes 21B into which the interconnections (through-electrodes) 28 are inserted.

According to the above-described embodiment, it is possible to provide the same operations and effects as those of the first embodiment.

In the second embodiment, the through-holes 21B are formed in the glass substrate 54B, resulting in an effect of dispensing with the step of exposing the glass substrate 54B and silicon substrate 51B in at least one side of the bonded substrate 55B.

In the second embodiment, furthermore, the bonding of the silicon substrate 51B and glass substrate 54B is performed while the silicon substrate 51B with the protrusions 11 formed therein covers the openings 21bB on the ends (the lower parts) of the respective through-holes 21B so as to prevent formation of a void. This can prevent formation of a void between the silicon substrate 10 and glass substrate 20, thus enabling to produce a device whose inside is highly airtight.

In the second embodiment, still furthermore, the gaps 60 are formed between the protrusions 11 and the respective through-holes (recesses or through-holes) 21B. Specifically, the gaps 60 are formed between the side surfaces 11a of the protrusions 11 and the respective inner surfaces 21aB formed at the portions of the glass substrate 54B corresponding to the through-holes 21B. The silicon substrate 51B and the glass substrate 54B can be easily laid on each other, thus facilitating the produce thereof.

According to the second embodiment, the substrate with through-electrode 50B with the gaps 60 formed between the interconnections (through electrodes) 28 and the glass substrate 20 can be obtained. The thus-obtained substrate with through-electrode 50B is less likely to be distorted even if being expanded.

In the example of the second embodiment, the through-holes 21B are formed in the glass substrate 54B. However, recesses may be formed in the glass substrate.

Specifically, it is possible to form a glass-embedded silicon substrate (substrate with through-electrode) 50C including the interconnections (through electrodes) 28 formed within the glass substrate 20 in the following manner.

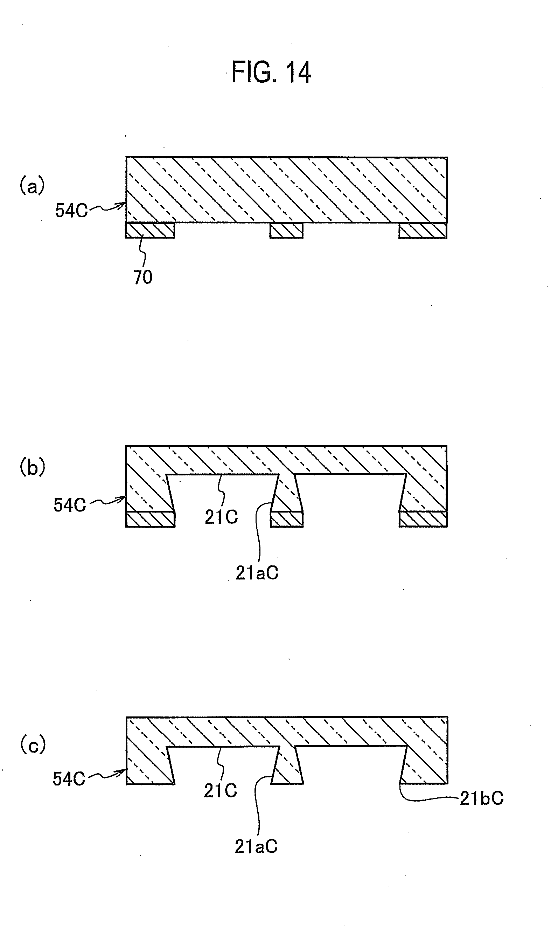

As shown in Fig. 14 (a), a glass substrate 54C is prepared, and resist 70 is formed on the glass substrate 54C. Thereafter, as shown in Fig. 14(b), predetermined areas in the surface of the glass substrate 54C are selectively removed by an RIE process or the like to form recesses 21C. After the recesses 21C are formed, the resist 70 is removed as shown in Fig. 11 (c). In such a manner, the glass substrate 54C with the recesses 21C formed thereon is formed (see Fig. 14 (c)). Each recess 21C has a tapered shape with the diameter increasing toward the top similarly to the aforementioned through-holes 21B.

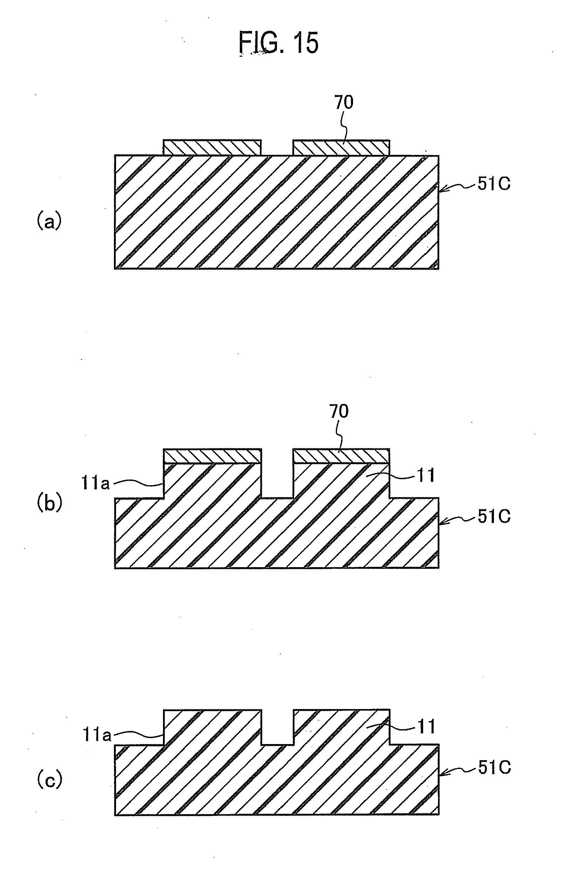

Next, as shown in Figs. 15(a) to 15(c), the protrusions 11 are formed in the silicon substrate 51C. The method of forming the protrusions 11 in the silicon substrate 51C is the same as the above-described method of forming the protrusions 11 in the silicon substrate 51B. The formation of the protrusions 11 in the silicon substrate 51C can be performed either before or after the formation of the recesses 21C in the glass substrate 54C or can be performed in parallel with the formation of the recesses 21C in the glass substrate 54C.

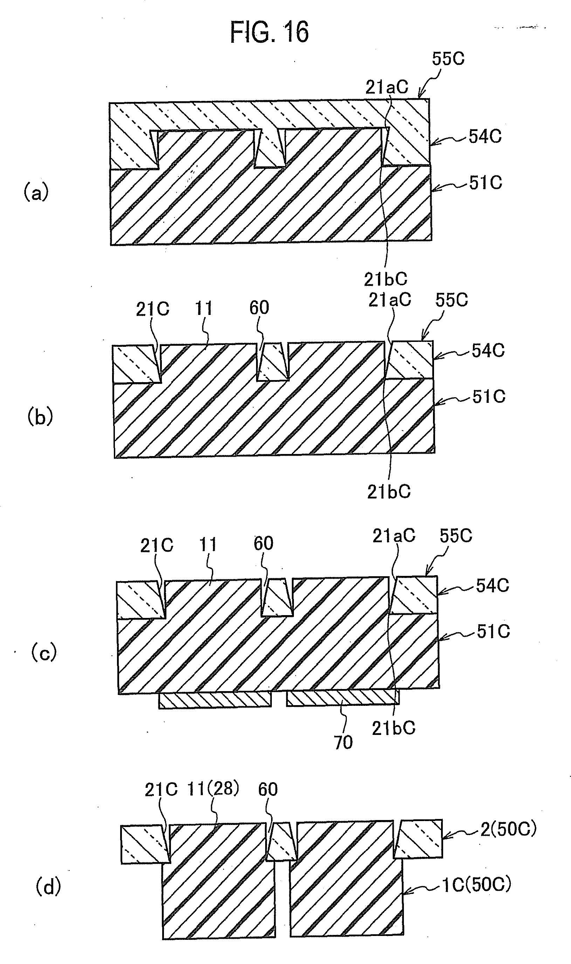

Next, the silicon substrate 51C and the glass substrate 54C are laid on each other so that the protrusions 11 are inserted in the respective recesses 21C. Specifically, first, the glass substrate 54C with the recesses 21C formed therein and the silicon substrate 51B with the protrusions 11 formed therein are prepared. As shown in Fig. 16(a), the protrusions 11 of the silicon substrate 51C are inserted into the recesses 21C of the glass substrate 54C, and the silicon substrate 51C is laid on the glass substrate 54C so that the protrusions 11 are in the respective recesses 21C. Since each recess 21C has a tapered shape with the diameter increasing toward the top as described above, the upper part of each recess 21C has a slightly larger diameter than that of the corresponding protrusion 11 of the silicon substrate 51C. Accordingly, there are a few gaps 60 formed between glass and silicon (between the side surfaces 11a of the protrusions 11 and inner surfaces 21aC formed at the portions of the glass substrate 54C corresponding to the respective recesses 21C). Accordingly, the lower part of each recess 21C has such dimensions as the lower part is properly engaged with the corresponding protrusion 11 of the silicon substrate 51C in a state where the silicon substrate 51C and the glass substrate 54C are laid on each other (see Fig. 16 (a)).

Next, the silicon substrate 51C and glass substrate 54C, which are laid on each other with the protrusions 11 inserted in the respective recesses 21C, are bonded by a method such as anodic bonding. This step may be performed either under ambient-pressure atmosphere or reduced-pressure atmosphere. Moreover, the bonding method is not limited to the anodic bonding and can be selected from various methods.

The silicon substrate 51C and glass substrate 54C are bonded in such a manner to form a bonded substrate 55C (see Fig. 13(a)).

The bonding of the silicon substrate 51C and the glass substrate 54C is performed while the silicon substrate 51C with the protrusions 11 formed therein covers each opening 21bC, which is located on an end of the corresponding recess 21B, so as to prevent formation of a void. In the second embodiment, the recesses 21C are formed so that the lower part of each recess 21C has such dimensions as the lower part is properly engaged with the corresponding protrusion 11 of the silicon substrate 51C. In the state where the silicon substrate 51C and the glass substrate 54C are laid on each other with the protrusions 11 inserted in the respective recesses 21C, the lower ends of the side surfaces 11a of the protrusions 11 abut on the respective lower ends of the inner surfaces 21aC formed in the portions of the glass substrate 54B corresponding to the through-holes 21C. In such a manner, the silicon substrate 51C with the protrusions 11 formed therein covers the openings 21bC, each of which is on an end (lower part) of the corresponding recess 21B, so as to prevent formation of a void, and in such a state, the silicon substrate 51C and the glass substrate 54C are bonded.

Thereafter, the glass substrate 54C and silicon substrate 51C are exposed in the upper surface (at least one side) of the bonded substrate 55C including the silicon substrate 51C and glass substrate 54C bonded to each other.

Specifically, as shown in Fig. 16 (b), the part of the glass substrate 54C embedded in the silicon substrate 51C is left, while the other part thereof is removed.

In this removal step, the upper surface of the glass substrate 54C is scraped off for removal of unnecessary glass using a method including diamond wheel grinding, polishing such as chemical mechanical polishing (CMP), dry etching such as RIE, or wet etching by HF.

Furthermore, as shown in Fig. 16(c), resist 70 is formed on the rear surface of the silicon substrate 51C, and then as shown in Fig. 16(d), predetermined areas in the rear surface of the silicon substrate 51C are selectively removed by an RIE process or the like.

In such a manner, the substrate with through-electrode 50C with the interconnections (through-electrodes) 28 formed within the glass substrate 20 is formed.

The substrate with through-electrode 50C formed in such a manner can provide substantially the same operations and effects as those of the aforementioned second embodiment.

In this embodiment, too, it is possible to form no gaps between the interconnections (through-electrodes) 28 and the glass substrate 20 as described in the first embodiment.

Moreover, the recess-protrusion relationship between the glass substrate and the silicon substrate may be reversed. Specifically, even if the protrusions are formed in the glass substrate while the through-holes or recesses are formed in the silicon substrate, the same effects can be obtained.

### (Third Embodiment)

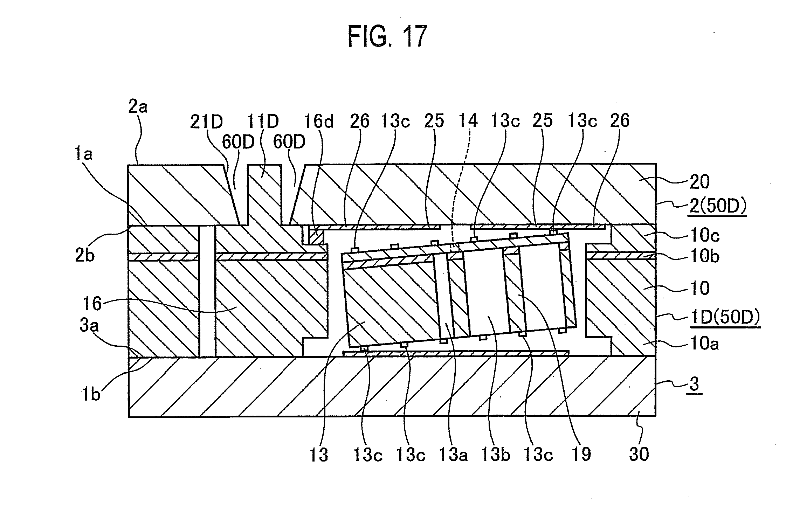

Fig. 17 is a cross-sectional view illustrating the schematic structure of an acceleration sensor chip A according to a third embodiment of the present invention. The acceleration sensor chip A according to the third embodiment basically has substantially the same structure as that of the acceleration sensor chip A shown in the second embodiment.

The acceleration sensor chip A according to the third embodiment is a capacitance acceleration sensor chip. The acceleration sensor chip A includes: a sensor body 1D formed by use of an SOI (silicon on insulator) substrate 10; a first fixed substrate 2 formed by use of a glass substrate 20; and a second fixed substrate 3 formed by use of a glass substrate 30.

The third embodiment is the same as the second embodiment in that the acceleration sensor chip A employs a substrate with through-electrode. The acceleration sensor chip A of the third embodiment has a structure in which protrusions 11 of the silicon substrate 10 are inserted into through-holes 21D formed in the glass substrate 20. A description is given below of a method for producing a substrate with through-electrode 50D according to the third embodiment.

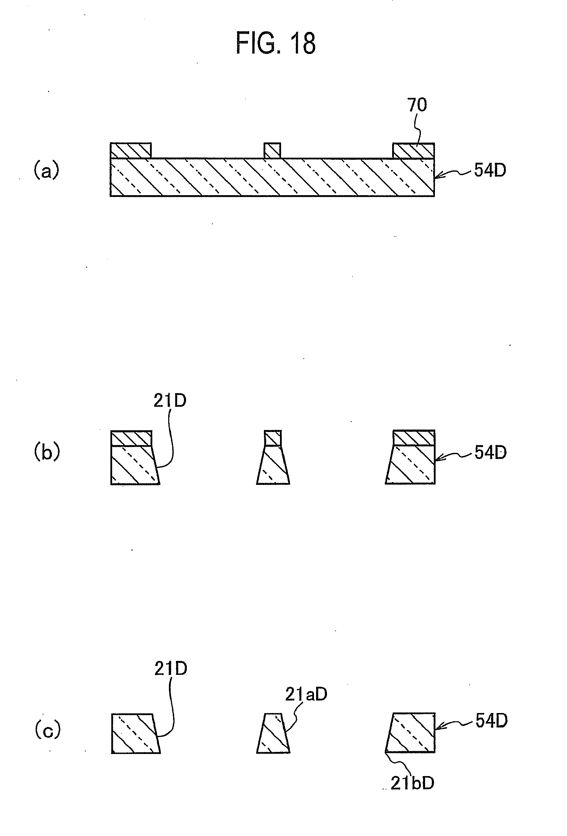

First, as shown in Figs. 18 (a) to 18(c), the through-holes 21D are formed in a glass substrate 54D. The method of forming the through-holes 21D in the glass substrate 54D is the same as the aforementioned method of forming the through-holes 21B in the glass substrate 54B.

Next, a description is given of a method of forming protrusions 11D in the silicon substrate 51D.

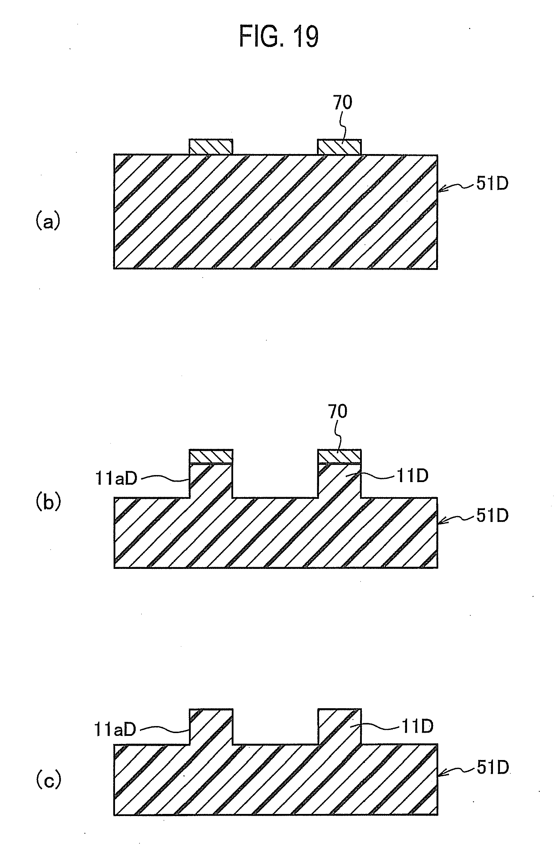

In the third embodiment, first, as shown in Fig. 19(a), the silicon substrate 51D having an electric resistance small enough is prepared. In the entire silicon substrate 51D, p-type or n-type impurities are added. Resist 70 is then formed on the surface of the silicon substrate 51D. Thereafter, as shown in Fig. 19 (b), predetermined areas in the surface of the silicon substrate 51D are selectively removed by an RIE process or the like to form the plural protrusions 11D. After the protrusions 11D are formed, the resist 70 is removed as shown in Fig. 19 (c). In such a manner, the silicon substrate 51D with the protrusions 11D formed therein is formed (see Fig. 19(c)). In the third embodiment, the protrusions 11D are formed so as to have a diameter a little smaller than the diameter of the protrusions 11 of the second embodiment.

Herein, in this example, impurities are added to the entire silicon substrate 51D, but the present invention is not limited to this. It suffices for the impurities to be added at least to the depth of a part left as the interconnections (through-electrodes) 28.

In this embodiment, the glass substrate 54D corresponds to one of the silicon substrate and glass substrate, and the silicon substrate 51D corresponds to the other one thereof.

The formation of the protrusions 11D in the silicon substrate 51D can be performed either before or after the formation of the through-holes 21D in the glass substrate 54D or can be performed in parallel with the formation of the through-holes 21D in the glass substrate 54D.

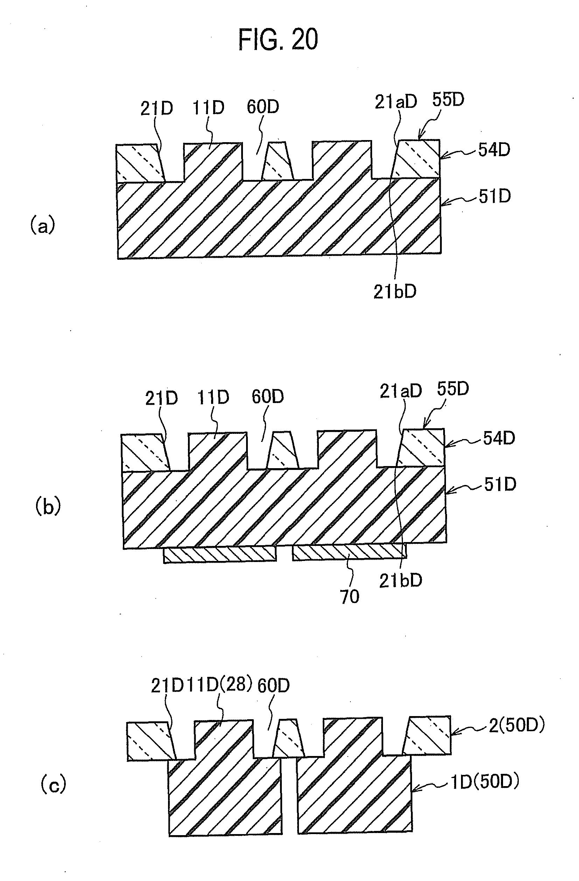

Next, the silicon substrate 51D and the glass substrate 54D are laid on each other so that the protrusions 11D are inserted in the respective through-holes 21D. Specifically, first, as shown in Fig. 20 (a), the glass substrate 54D with the through-holes 21D formed therein and the silicon substrate 51D with the protrusions 11D formed therein are prepared. As shown in Fig. 20 (b), the protrusions 11D of the silicon substrate 51D are inserted into the through-holes 21D of the glass substrate 54D, and the silicon substrate 51D is laid on the glass substrate 54D so that the protrusions 11D are inserted in the respective through-holes 21D.

In the third embodiment, each through-hole 21D has a tapered shape with the diameter increasing toward the top. The diameter of each through-hole 21D is a little larger than that of the corresponding protrusion 11D of the silicon substrate 51 at any position from the top to the bottom. Accordingly, gaps 60D are formed between glass and silicon (between side surfaces 11aD of the protrusions 11D and respective inner surfaces 21aD formed at the portions of the glass substrate 54D corresponding to the through-holes 21D in the state where the protrusions 11D are inserted in the respective through-holes 21D) from the top to the bottom (see Fig. 20 (a)). In other words, in the state where the protrusions 11D are inserted in the through-holes 21D, the side surfaces 11a of the protrusions 11D do not abut on the respective inner surfaces 21aD formed at the portions of the glass substrate 54D corresponding to the through-holes 21d. Accordingly, the silicon substrate 51D and glass substrate 54D which are laid on each other can move relatively to each other in an arbitrary direction in the abutment surfaces (an upper surface 51aD of the silicon substrate 51d and a lower surface 54aD of the glass substrate 54) before the silicon substrate 51D is bonded to the glass substrate 54D.

Next, the silicon substrate 51D and glass substrate 54D, which are laid on each other with the protrusions 11D inserted in the respective through-holes 21D, are bonded by a method such as anodic bonding. This step may be performed either under ambient-pressure atmosphere or reduced-pressure atmosphere. Moreover, the bonding method is not limited to the anodic bonding and can be selected from various methods.

The silicon substrate 51D and glass substrate 54D are bonded in such a manner to form a bonded substrate 55D (see Fig. 20(b)).

The silicon substrate 51D and glass substrate 54D are bonded while the silicon substrate 51D with the protrusions 11D formed therein covers each opening 21Db at an end (lower part) of the corresponding through-hole 21D so as to prevent formation of a void. In the third embodiment, the opening 21bD on the end (lower part) of each through-hole 21D is covered with the periphery of the corresponding protrusion 11D in the upper surface 51aD of the silicon substrate 51D. In such a state, the silicon substrate 51 and glass substrate 54D are bonded to each other.

Furthermore, the resist 70 is formed on the rear surface of the silicon substrate 51C as shown in Fig. 20(b), and then, the predetermined areas in the rear surface of the silicon substrate 51C are selectively removed by an RIE process or the like as shown in Fig. 20(c).

The substrate with through-electrode 50D with the interconnections (through-electrodes) 28 formed within the glass substrate 20 is thus formed.

The substrate with through-electrode 50D formed in such a manner can provide the same operations and effects as those of the second embodiment.

Moreover, in the third embodiment, each gap 60D is formed from the top to the bottom between glass and silicon (between a side surface 11aD of each protrusion 11D and an inner surfaces 21aD formed at the portions corresponding to the corresponding through-hole 21D of the glass substrate 54D in the state where the protrusion 11D are inserted in the respective through-holes 21D). In other words, in the state where the protrusions 11D are inserted in the through-holes 21D, the side surfaces 11aD of the protrusions 11D do not abut on the inner surfaces 21aD formed at the portions of the glass substrate 54D corresponding to the through-holes 21D. Accordingly, the silicon substrate 51D and glass substrate 54D can be laid on each other more easily, thus further facilitating the produce.

According to the third embodiment, the substrate with through-electrode 50D with the gaps 60D formed between the interconnections (through-electrodes) 28 and the glass substrate 20 can be obtained. The thus-obtained substrate with through-electrode 50 is less likely to be distorted even when being expanded.

In the third embodiment, it is also possible to use a glass substrate including recesses as shown in the modification of the second embodiment.

Moreover, the recess-protrusion relationship between the glass substrate and silicon substrate may be reversed. Specifically, even if the glass substrate is provided with the protrusions while the silicon substrate is provided with through-holes or recesses, the same effects can be obtained.

The preferred embodiments of the present invention are described above. The present invention is not limited to the above-described embodiments and can be variously changed.

For example, in the first embodiment, the diameters of the recesses and protrusions can be adjusted so that gaps are formed between the silicon and glass substrate similarly to the second or third embodiment.

Moreover, in the example of the above-described first embodiment, the recesses are formed in any one of the silicon and glass substrates. However, through-holes may be formed instead of the recesses. For example, the glass substrate 54B with the through-holes 21B formed as shown in Fig. 11(c) can be applied to the first embodiment.

Furthermore, in the examples shown in the second and third embodiments, the silicon substrate with only the protrusions formed therein is bonded to the glass substrate. After the bonding, predetermined areas of the rear surface of the silicon substrate are removed. However, the present invention is not limited to this, and it is possible to bond the glass substrate to the silicon substrate after forming the protrusions and removing the predetermined areas of the rear surface. Specifically, the silicon substrate may have a shape as shown in Figs. 13(c), 16(d), or Fig.20(c) to be bonded to the glass substrate.

Moreover, the above-described embodiments show the acceleration sensor detecting accelerations in two directions: the directions x and z. The acceleration sensor of the present invention may be configured as an acceleration sensor detecting accelerations in three directions (including the direction y) by rotating one of the weight portions 90 degrees in the X-Y plane.

Moreover, the acceleration sensor is shown as the capacitance device in the examples of the above-described embodiments. However, the present invention is not limited to this and can be also applied to another capacitance device.

The detailed specifications (the shape, the size, the layout, and the like) of the weights, fixed electrodes, and others can be properly changed.

### INDUSTRIAL APPLICABILITY

According to the present invention, it is possible to provide a substrate with through-electrode and a producing method thereof in which the influence on the device characteristics is minimized.

## Claims

1. A method for producing a substrate with through-electrode comprising steps of:
forming a recess or a through-hole in either one of silicon and glass substrates;
forming a protrusion in the other substrate;
laying the silicon substrate and glass substrate on each other so that the protrusion is inserted in the recess or through-hole; and
bonding the silicon substrate and the glass substrate to each other.

2. The method for producing the substrate with through-electrode according to claim 1, further comprising a step of:
exposing the glass substrate and silicon substrate at least in one side of a bonded substrate composed of the silicon substrate and glass substrate bonded to each other.

3. The method for producing the substrate with through-electrode according to claim 1 or 2, wherein the silicon substrate and glass substrate are bonded to each other while the substrate with the protrusion formed covers an opening of the recess or an opening of the through-hole to prevent formation of a void.

4. The method for producing the substrate with through-electrode according to any one of claims 1 to 3, wherein a gap is formed between the protrusion and the recess or between the protrusion and the through-hole.

5. A substrate with through-electrode, comprising a glass substrate including a through-electrode formed therein, wherein a gap is formed between the through-electrode and the glass substrate.
